# EUROPEAN PATENT SPECIFICATION

(11) **EP 0 715 493 B1**
(45) Date of publication and mention of the grant of the patent: **27.09.2000**
(21) Application number: 96101597.1
(22) Date of filing: 26.07.1993
(51) Int. Cl.: H05K 13/04, H05K 13/08

(54) **Method for mounting chip components and apparatus therefor**
Verfahren zum Montieren von Chip-Bauteilen und Gerät dafür
Méthode de montage de composants en forme de pastille et appareil pour cela

(30) Priority: 07.08.1992 JP 2183992; 13.05.1993 JP 11127093
(43) Date of publication of application: 05.06.1996
(62) Divisional of application: 93111932.5
(73) Proprietor: YAMAHA HATSUDOKI KABUSHIKI KAISHA, Iwata-shi Shizuoka-ken, 438 (JP)
(72) Inventor: Onodera, Hitoshi, Iwata-shi, Shizuoka-ken (JP); Sakurai, Hiroshi, Hamamatsu-shi, Shizuoka-ken (JP)
(74) Representative: Grünecker, Kinkeldey, Stockmair & Schwanhäusser Anwaltssozietät

(56) References cited:
- EP-A- 0 293 175
- WO-A-85/02088
- GB-A- 2 183 820

## Description

The present invention relates to a method for mounting chip components at specific positions, preferably on a substrate such as a printed circuit board, comprising: a main mounting operation, including the steps of attracting one of said components by an attracting nozzle associated with a moveable head unit from a components supply unit, transferring the chip component, placing the same in a detection area of an optical detecting means, measuring the projection width of the chip component (20) in the attracted state within the detection area comprised of parallel light beams, and, subsequently, mounting the component at the desired position, and a preparatory nozzle detecting process preceding the main mounting operation for detecting whether or not the attracting nozzle has a shape and/or position adapted to the chip component to be mounted.

Further, the invention relates to an apparatus for mounting chip components at specific positions, preferably on a substrate such as a printed circuit board, comprising a moveable head unit supporting an attracting nozzle for attracting a chip component by vacuum suction and transferring the same from a component supply side to a component mounting side, means for raising or lowering the attracting nozzle, optical detecting means for detecting a shape and/or a position of the chip component including means for detecting the projection width of the chip component by parallel light beams emitted from a beam emitting portion and received by a light beam receiving portion provided on the head unit, and a main control unit for controlling the mounting operation.

A component mounting apparatus adapted for attracting a component, such as a chip component from a component feeding section such as a tape feeder etc., by a component mounting head unit equipped with at least one attracting nozzle, transferring said component to the printed substrate disposed at a mounting position and mounting the component at the desired position on the substrate has already been proposed. Said apparatus provides a head unit movable in both X-axis and Y-axis directions whereas the attracting nozzle is movable in the Z-axis direction while being rotatable. Moreover, driving mechanisms are provided for transfers and movements of the mounting head as well as of the nozzle in various directions and for rotation of the nozzle, these driving means including vacuum supplying means for generating sucking vacuum at the nozzle for attracting the component are controlled by a controller section so that the chip component can be attracted and mounted automatically.

It has already been proposed that the chip component in its attracted state is detected by an optical detecting means to decide whether the chip component is attracted normally or not so that discrepancies in the attracting position of the chip component can be recognized and overcome.

In some modification of said apparatus, it has already been proposed also that a plurality of attracting nozzles is mounted at the mounting head unit.

However, it is desirable that attracting nozzles correspond to the kind of chip components to be mounted and the most appropriate attracting nozzle having different nozzle diameters etc., be selected and installed in the head unit when the kind of chip components to be mounted changes adapting the selection of attracting nozzles to such changes correspondingly. The installation and exchange of attracting nozzles on the head unit is carried out either manually or automatically between a nozzle exchanging station and the head unit.

At such apparatus, in case where miswork or an assembling error arises while installing the attracting nozzle on the head unit, various troubles might be caused. For example, in the case where there are error occurring in respect to the installing position of the attracting nozzle or the installing angle or there are other installing errors caused by a bend or misalignment of the attracting nozzle, the subsequent mounting procedure suffers from lacking accuracy and, for example, a decision as to whether the component has been properly attracted or not cannot be made efficiently. Moreover, in the process of installing or exchanging an attracting nozzle on the head unit a wrong attracting nozzle could erroneously be used, i.e., an attracting nozzle different from the proper one attributed to the chip component to be attracted and mounted. Such a mistake can not only be caused during manual operation but also even during automatic nozzle exchange by erroneously inputting the designation of the nozzle. In the case such a mistake is overlooked, troubles such as successive occurrence of defective attractions can be caused during the subsequent mounting operation.

EP-A-0 293 175 discloses a method and apparatus for mounting chip components according to the preamble of claims 1 and 8, respectively.

In view of the afore-indicated deficiencies, it is an objective of the present invention to provide an improved method for mounting chip components capable of both clearly distinguishing any miswork or assembling error caused by improper installation of the attracting nozzle on a head unit of the apparatus and clearly distinguishing any improper attracted state of the component occurring in the subsequent mounting procedure.

Moreover, it is another objective to provide an improved mounting apparatus which allows both mismounted or misaligned attracting nozzles disposed on a mounting head to be recognized, to attribute the proper attracting nozzle to mount a corresponding component chip and to assure a smooth mounting procedure by recognizing the attracted state of the component, preferably adapted to perform the afore-indicated method.

According to the present invention, the above-identified first objective, in terms of the method features of the preamble portion of claim 1 is solved in that said optical detecting means is also used for said preparatory nozzle detecting process and in that, during the main operation, said chip component is rotated and a projection width minimum value of the chip component is detected.

Accordingly, the attracting condition of the chip component is monitored by means of detecting a projection width of the chip component under rotation about the longitudinal axis of the attracting nozzle and, therefore, improper attracting state can be discriminated and the mounting cycle can be interrupted removing the deficiency and the mounting cycle can be restarted. Furthermore, in case of miswork or an assembling error in installing a respective attracting nozzle on the head unit, same can be detected in a preparatory stage before the main operation of the mounting process and the improper state caused by assembly faults can be eliminated or an adjustment to compensate for any assembling error can be made on the basis of the nozzle element detection process and the decision based thereon.

Preferred embodiments of the mounting method according to the present invention are laid down in the further subclaims.

According to a preferred embodiment of the method of the present invention and its advantageous developments, any improper installation of an attracting nozzle at the head unit is distinguished and corrected, prior to the commencement of the essential main mounting operation.

According to the present invention the above indicated second objective in terms of an apparatus for mounting the chip components at specific positions comprising the features as indicated in the preamble portion of claim 8 is solved in that the apparatus is arranged to use the same optical detecting means for detecting whether or not the attracting nozzle has a shape and/or a position adapted to the chip component to be mounted, and in that the apparatus further comprises servo motors for moving the head unit and, hence, the nozzle and the chip component attracted thereto in a direction in line with the parallel light beams and in a direction perpendicular thereto, respectively, means for rotating the nozzle and thereby the chip component attracted thereto, and calculating means for calculating chip component mounting correction amounts on basis of the data detected by said optical detection means when detecting the rotational position of the chip component which is varied in order to measure the projection width minimum value of the chip component.

Further preferred embodiments of said apparatus, according to the present invention, specifically adapted to perform the afore-indicated method are laid down in the further subclaims.

In the following, the present invention is explained in greater detail by means of several embodiments of the present invention in conjunction with the accompanying drawings:
Fig.1 is a plan view of a component mounting apparatus according to an embodiment of this invention,
Fig.2 is a front view of the apparatus above,

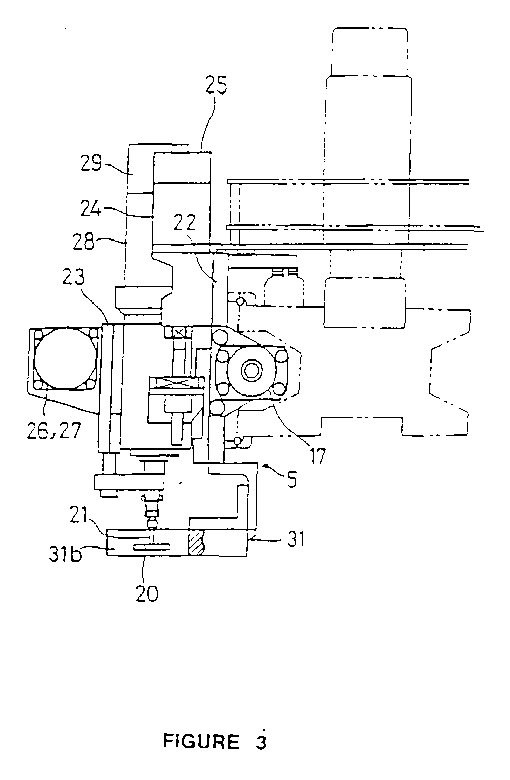

Fig.3 is an enlarged side view of a head unit for component mounting,
Fig.4 is an enlarged front view of a nozzle exchanging station,
Fig.5 is a block diagram showing a control system,
Fig.6 is a flow chart showing the exchange of the attracting nozzle and the process for deciding whether the exchange is normal of abnormal,
Fig.7(a) is an explanatory illustration showing the nozzle position while the nozzle diameter is being detected,
Fig.7(b) is an explanatory illustration showing the state of the attracting nozzle irradiated with laser beam,
Fig.8 is a flow chart showing the practical procedure for attracting and mounting components,
Fig.9 is an explanatory illustration showing the state while detecting the chip component projection width,
Figs.10(a) through 10(c) are illustrations showing attracted states of the chip component among which Fig.10(a) shows a normal state while Figs.10(b) and 10(c) show abnormal states,
Fig.11 is an illustration for showing how to obtain the mounting position correction amounts, etc.
Fig.12 is a schematic perspective view of a chip component having a special shape,
Fig.l3 is part of a flow chart extracted for showing the process for deciding the attracted state in the case of a chip component having a special shape,
Fig. 14 is a block diagram showing the structure of another main controller in the control system of an apparatus
Fig.15 is a flow chart showing the process as the reference nozzle height detecting means,
Figs.16(a) and 16(b) are explanatory illustrations for describing the operations in the flow chart of Fig.15,
Fig.17 is an explanatory illustration for the calculation of the recognizing height,
Fig.18 is a flow chart showing the process as the rotation center detecting means,
Fig.19 is an explanatory illustration showing the discrepancy between the rotation center and the nozzle center,
Fig.20 is an explanatory illustration showing the locus of the nozzle center and the rotation center, and
Fig.21 is an explanatory illustration showing the displacement of the nozzle center versus the nozzle rotation angle.

An embodiment of this invention is described referring to appended drawings.

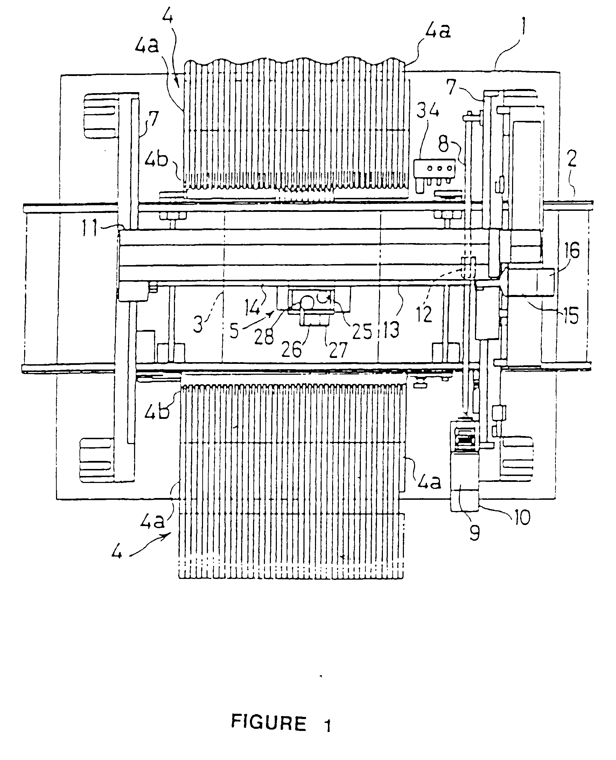

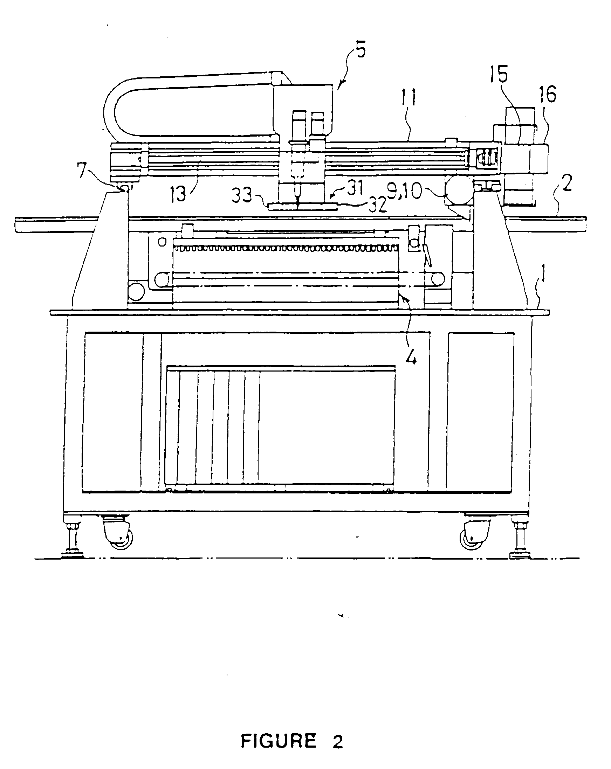

Figs.1 and 2 show the overall structure of a component mounting apparatus according to an embodiment of this invention. As shown in these drawings, on the base 1 is disposed a conveyer 2 for conveying printed substrates 3, and the printed substrate 3 is conveyed on the conveyer 2 and is stopped at a definite position on the mounting station.

On the sides of the conveyer 2 are disposed component feeding sections 4 provided with multiple rows of feeder tapes 4a, each of which contains and holds chip components such as ICs, transisters, condensers, etc., at regular intervals and is wound round a reel. A ratchet type send-out mechanism is incorporated at the send-out end 4b of the feeder tape 4a so that the feeder tape 4a may be intermittently sent out and the pick-up operation may be repeated as a chip component 20 is picked up from the send-out end 4b by the head unit 5.

The head unit 5 adapted for transferring both in the X axis direction (direction of the conveyer 2) and in the Y axis direction (direction perpendicular to the X axis direction on a horizontal plane) is installed above the base 1.

That is, while a pair of fixed rails 7 extended in the Y axis direction across the conveyer 2 are disposed on the base 1 in parallel with each other keeping a specified distance therebetween, a ball screw 8 to be rotated by a Y axis servomotor 9 is disposed near one fixed rail 7 as the feed mechanism in the Y axis direction. A support member 11 for supporting the head unit 5 is movably supported on both fixed rails 7 , and the nut portion 12 of the support member 11 at one end thereof is in screw-engagement with the ball screw 8 so that the support member 11 may be transferred in the Y axis direction by the rotation of the ball screw 8. The Y axis servomotor 9 is provided with Y axis position detecting means 10 constituted of an encoder.

The support member 11 is, while being provided with guide rails 13 extended in the X axis direction, equipped with a ball screw 14 disposed near the guide rails 13 and an X axis servomotor 15 for rotating the ball screw 14 as an X axis direction feed mechanism. The head unit 5 is movably supported on the guide rails 13, and the nut portion 17 provided on the head unit 5 is in screw-engagement with the ball screw 14 so that the head unit 5 may be transferred in the X axis direction by the rotation of the ball screw 14. The X axis servomotor 15 is provided with X axis position detecting means 16.

The head unit 5 has attracting nozzles 21 for attracting chip components 20 installed thereon for up-down transfer and rotation. In this embodiment, the head unit 5 has a mounting member 22 supported for transfer on the guide rails 1, a head 23 installed on the mounting member 22 for up-down transfer and attracting nozzles 21 made transferrable up and down relative to the head 23 and rotatable about the R axis (nozzle center axis). The mounting member 22 is, while being provided with a nut portion 17, equipped with a head raising/lowering servomotor 24, and the head 23 is equipped with an attracting nozzle raising/lowering servomotor 26 and an attracting nozzle rotating R axis servomotor 28. The head raising/lowering servomotor 24 and the attracting nozzle raising/lowering servomotor 26 constitute up-down driving means for the attracting nozzle, and the R-axis servomotor 28 constitutes rotation driving means.

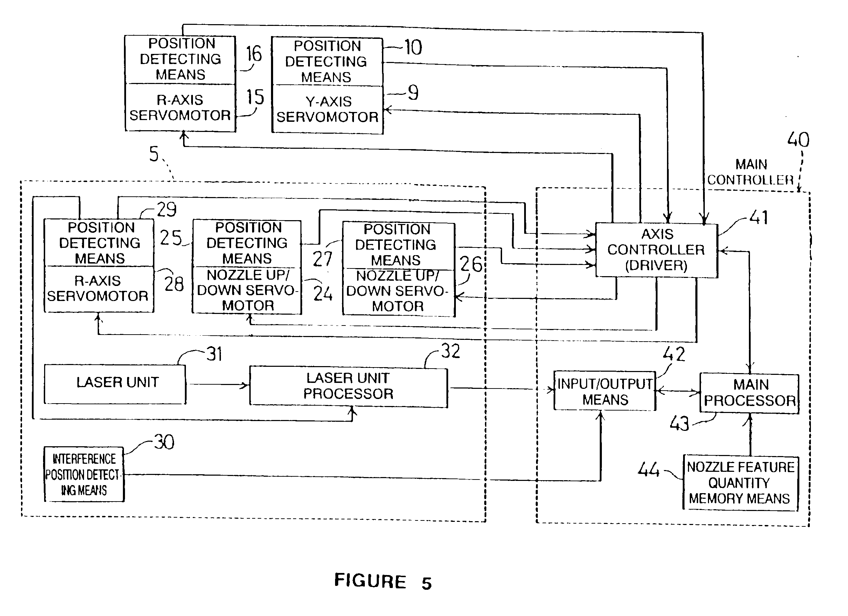

The servomotors 24, 26 and 28 are provided with position detecting means 25, 27 and 29 respectively. Further, interference position detecting means (See Fig.5) for detecting the interference position of the attracting nozzle 21 with the component feeding section 4 is installed on the head unit 5.

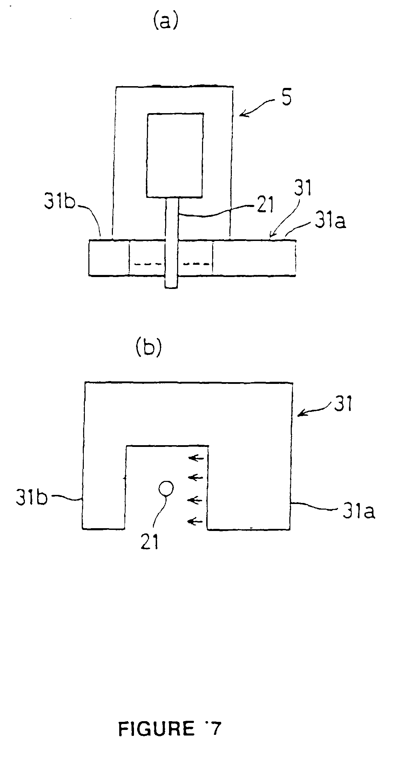

On the lower end portion of the head unit 5 is installed a laser unit 31 constituting optical detecting means. This laser unit 31 serves both as means for detecting the nozzle diameter described later and as means for detecting the projection width of a chip component, and has a laser beam producing portion (parallel ray emitting portion) 31a and a detector (ray receiving portion) 31b facing each other with an attracting nozzle positioned therebetween (See Fig.7). The detector 31b is constituted of a CCD.

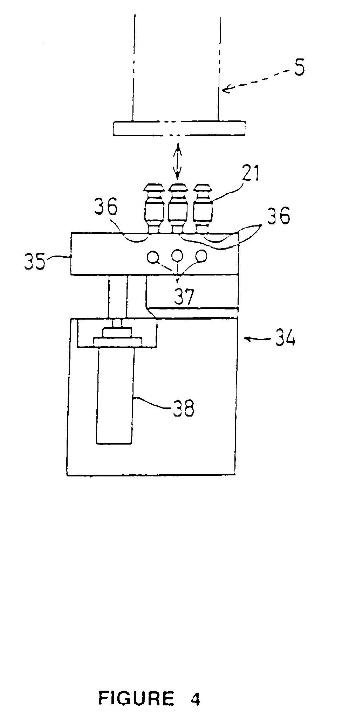

At a suitable position within the moving range of the head unit 5 on the base 1 is installed a nozzle exchange station 34 which, as shown in Fig.4, is provided with a nozzle clamp plate 35, a nozzle holding portion 36 disposed on the plate 35 to releasably hold a plurality of kinds of attracting nozzles 21 having different external form feature quantities such as nozzle diameters, etc., nozzle distinguishing sensors 37 for distinguishing the existence of the nozzles, raising/lowering cylinder 38, etc. When exchanging attracting nozzles, the head unit 5 is transferred to the position corresponding to this nozzle exchanging station 34 so that the attracting nozzles 21 may be exchanged between both.

Fig.5 shows an embodiment of the control system in which the servomotors 9, 15, 24, 26 and 28 for the X direction transfer, for the Y direction transfer, for raising/lowering the head on the head unit, for raising/lowering attracting nozzles and for rotation about the R axis, respectively, and position detecting means 10, 16, 25, 27 and 29 respectively for the sevomotors above are electrically connected to the axis controller (driver) 41 of the main controller 40. The laser unit 31 is electrically connected to the laser unit processor 32 which is in turn connected to the main processor 43 through the input/output means 42 of the main processor 43 Further, the interference position detecting means 30 is connected to the input/output means 32. The main controller 40 is provided with nozzle feature quantity memory means 44 which stores the external feature quantities corresponding to the kind of the attracting nozzles 21, more practically saying, stores a table of the nozzle diameter corresponding to the kinds of the attracting nozzles 21.

The main processor 43 carries out various processing operation required for attracting and mounting chip components during the main operation for attracting from the component feeding section 4 and mounting chip components on the printed substrate 3 at the predetermined positions by the head unit 5, while, in the stage of the preparatory operation for installing the attracting nozzle 21 on the head unit 5, carries out nozzle element detecting operation for detecting the elements representing the form or position of the attracting nozzle installed on the head unit and deciding or setting operations for the attracting nozzle on the basis of this nozzle element detecting operation. In this embodiment, as the nozzle element detecting operation in the preparatory operation, the external feature quantities of the attracting nozzle 21 installed on the head unit 5 [practically, the nozzle diameter) is detected by the laser unit 31, and decides whether the attracting nozzle is a proper one or not by comparing the detected value with the nozzle diameter of the proper attracting nozzle (attracting nozzle to be selected according to the kind of the chip component 20 to be attracted and mounted) read out of the nozzle feature quantity memory means 44. Thus, the main processor 43 constitutes comparing deciding means.

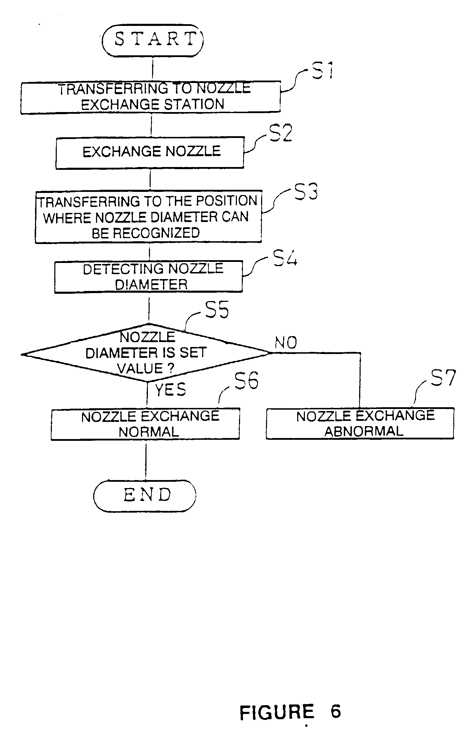

Fig.6 shows the process for exchanging the attracting nozzle 21 and deciding whether the exchanged nozzle is proper or not in the preparatory stage for attracting and mounting components as a flow chart. The operation in this flow chart is described referring to operation explanatory illustrations of Figs.7(a) and 7(b).

In this operation, first the head unit 5 is transferred to the nozzle exchange station 34 at the step S1, and the nozzle is exchanged at the next step S2. Then, the attracting nozzle 21 is transferred to the position at which the nozzle diameter can be recognized at the step S3, that is, into the state in which the portion of the attracting nozzle near the tip end thereof corresponds to the laser unit 31.

In this state, the nozzle diameter is detected by the laser unit 31 (step S4). That is, as shown in Fig.7(b), laser beam (arrow mark) is emitted from the laser generator 31a, and the projection width of the attracting nozzle, i.e., the nozzle diameter of the attracting nozzle, is detected by the detector 31b receiving the laser beam.

At the next step S5, the detected value above of the nozzle diameter is compared with the set value for the proper attracting nozzle read out of the nozzle feature quantity memory means 44, and the nozzle exchanged is decided to be normal when the detected nozzle diameter is equal to the set value (step S6) or to be abnormal when the detected nozzle diameter is not equal to the set value (step S7). When the exchanged nozzle is found abnormal, the abnormality will be indicated by a pilot lamp, etc., and the attracting and mounting operations thereafter will be suspended.

In the case where an improper attracting nozzle is installed by mistake when exchanging the attracting nozzle, this exchange abnormality is made clear by the process shown in this flow chart.

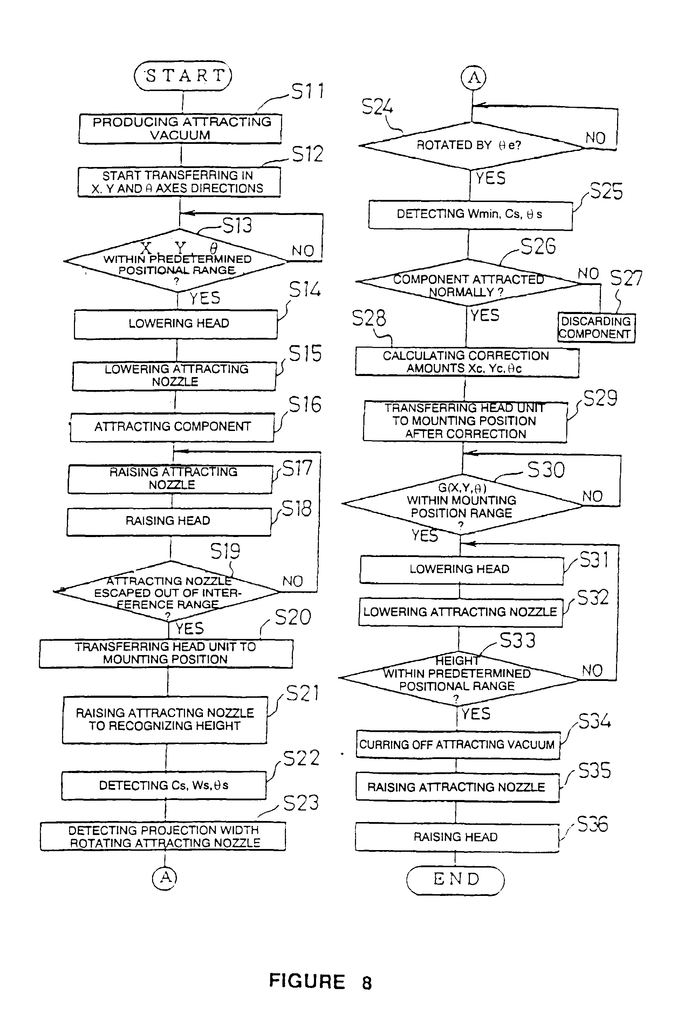

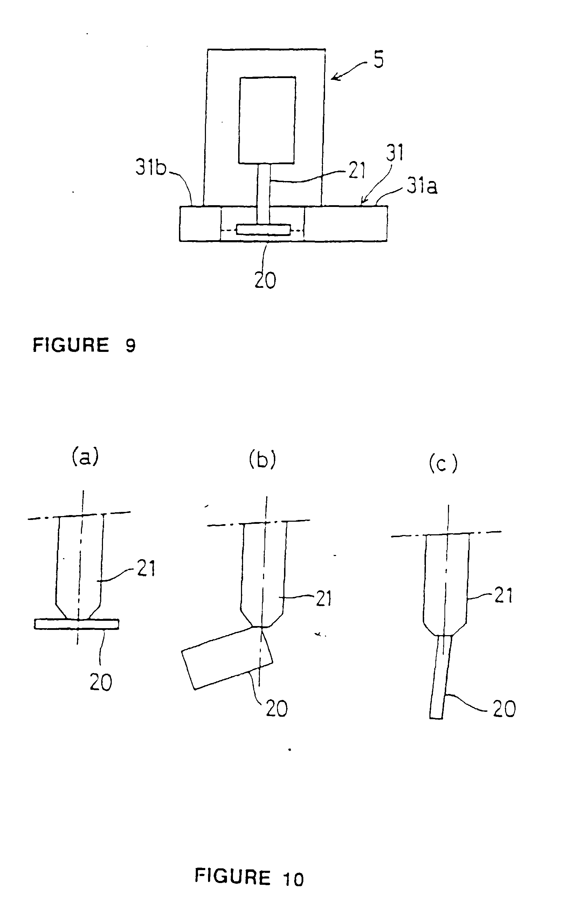

Fig.8 shows a series of processes from attraction to mounting of a chip component after the processes on the preparatory stage described above as a flow chart including processes for correcting errors caused by scattering of the position and direction of the chip component at the attraction. The processes in this flow chart is described hereafter also referring to Figs.9 through 11.

While the attracting nozzle 21 is supplied with attracting vacuum by vacuum producing means not shown here at the first step S11, it is transferred in the X axis and Y axis directions and its rotation about the θ axis are started by actuating respective servomotors at the step S12. At the step S13, it is examined in succession whether the center coordinates (X, Y and θ) of the attracting nozzle 21 have come into the positional range predetermined for attraction. When having come into the predetermined positional range, the head unit 23 is lowered at the step S14, the attracting nozzle 21 is also lowered at the step S15, a chip component 20 is attracted to the attracting nozzle 21 from the feeder tape 4a of the component feeding section 4 at the step S16, then the attracting nozzle 21 is raised at the step S17, and also the head 23 is raised at the step S18.

At the step S19, it is examined whether the attracting nozzle 21 has reached a height for escaping out of the range of its interference with the component feeding section 4, and the steps S17 through 19 are repeated while it does not reach the height above. When has escaped out of the range of its interference, the head unit 5 is transferred to the component mounting position at the step S20, and the attracting nozzle 21 is raised to the chip component recognizing height at the step S21, that is, to the height at which the chip component corresponds to the laser unit 31 as shown in Fig.9. In this state, while the attracted state of the chip component is examined, processes for obtaining mounting position correction amounts (steps S22 through S28) are carried out. To assure the detection of the minimum projection width (described later), etc., it is preferrable to preliminarily rotate the attracting nozzle 21 prior to the step S22 in a sense contrary to that of the rotation for detection.

At the step S22, the projection width Wₛ, center position Cₛ and the rotation angle θₛ at that time are detected. At the step S23, the component projection width is detected in succession while rotating the attracting nozzle 21 in a predetermined sense. When it is decided that the attracting nozzle 21 has been rotated by a definite rotating angle θₑ at the step S24, the minimum value Wₘᵢₙ of the projection width, the center position Cₘ and the rotation angle θₘ at the minimum projection width are read in at the step S25. Then, it is decided at the step 26 whether the component attraction is normal or not on the basis of the detected data, the component is discarded at the step S27 if not normal, and the mounting position correction amounts X_{c}, Y_{c} and θ_{c} in the X, Y and θ directions, respectively, are calculated on the basis of the detected data at the step S28.

At the step S26 above, it is decided whether the chip component is attracted normally as shown in Fig.10(a) or abnormally in erected states as shown in Figs.10(b) and 10(c). Practically, it is examined whether the following equations hold or not, and the attracted state is decided to be abnormal if any one of following equations holds. The value α in the equations is a safety factor.${\text{[eq. 1] W}}_{\text{min}} \text{< (length of shorter side of component) × (1 - α)} {\text{W}}_{\text{min}} \text{> (length of longer side of component) × (1 + α)} {\text{θ}}_{\text{m}} {\text{=θ}}_{\text{s}} {\text{θ}}_{\text{m}} {\text{=θ}}_{\text{e}}$

The correction amounts X_{c}, Y_{c} and θ_{c} are calculated at the step S28 as follows:

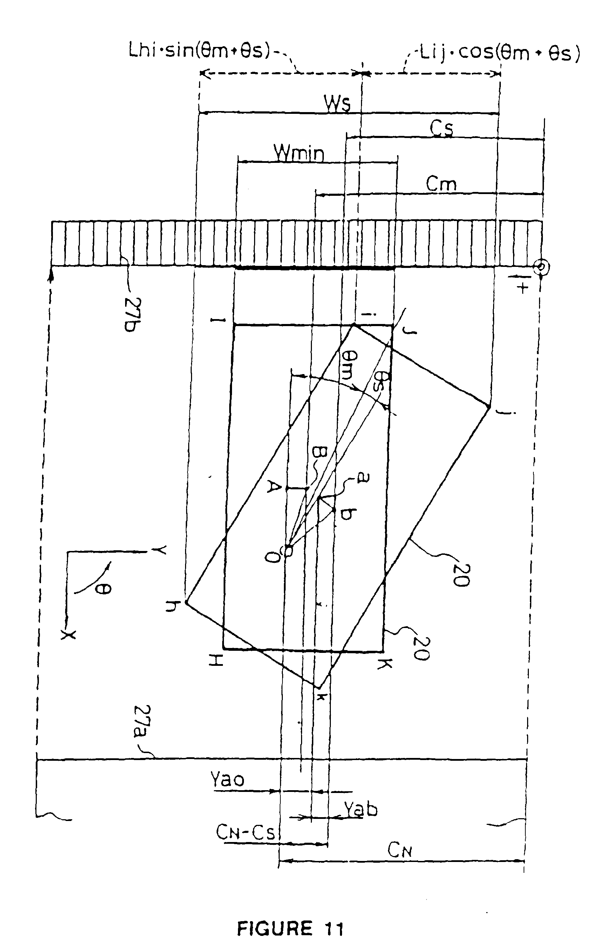

As is clearly seen in Fig.11, when the chip component 20 is attracted in a state with its longer side directed in the X axis direction, the correction amounts Y_{c} in the Y axis direction and θ_{c} in the θ direction among the component mounting position correction amounts X_{c}, Y_{c} and θ_{c} are given by:${\text{[eq. 2] Y}}_{\text{c}} {\text{= C}}_{\text{m}} {\text{-C}}_{\text{N}} \text{, and} {\text{θ}}_{\text{c}} {\text{= θ}}_{\text{m}} \text{,}$ where C_{N} represents the center position (attracting point) of the attracting nozzle, and is a known value.

In Fig.11, 0 is the center point of the attracting nozzle, b and B are chip component center points in the initial state and in the minimum projection width state, respectively, and Δa0b≡ΔA0B.

When taken as follows:
L_{AB} : length of the segment AB,
L_{ab} : length of the segment ab,
L_{AO} : length of the segment A0,
L_{aO} : length of the segment a0,
Y_{ab} : projection length of the segment ab on the Y axis, and
Y_{aO} : projection length of the segment a0 on the Y axis,
${\text{[eq. 3] C}}_{\text{N}} {\text{- C}}_{\text{S}} {\text{= Y}}_{\text{aO}} {\text{+ Y}}_{\text{ab}} \text{,}$${\text{[eq. 4] Y}}_{\text{aO}} {\text{= L}}_{\text{aO}} {\text{·sin(θ}}_{\text{m}} {\text{+θ}}_{\text{s}} \text{),}$ and${\text{[eq. 5] Y}}_{\text{ab}} {\text{= L}}_{\text{ab}} {\text{·cos(θ}}_{\text{m}} {\text{+θ}}_{\text{s}} \text{).}$ Since Lₐₒ = L_{Ao} = X_{c}, and L_{ab} = L_{AB} = C_{N} - Cₘ, X_{c} is derived from the equations above as shown in the following equation:${\text{[eq. 6] X}}_{\text{c}} {\text{= {(C}}_{\text{N}} {\text{- C}}_{\text{s}} {\text{) - (C}}_{\text{N}} {\text{- C}}_{\text{m}} {\text{)·cos(θ}}_{\text{m}} {\text{+θ}}_{\text{s}} {\text{)}/sin(θ}}_{\text{m}} {\text{+θ}}_{\text{s}} \text{).}$

When the calculation at the step S28 is completed, the head unit 5 is transferred to the corrected component mounting position at the step S29, and it is decided at the step S30 whether the center coordinate G(X, Y, θ) of the chip component has reached the mounting position range on the printed substrate 3 or not. If reached, the head 23 is lowered at the step S31, the attracting nozzle 21 is also lowered at the step S32, then, when the height of the attracting nozzle 21 has reached the predetermined height range at the step S33, the vacuum is cut off at the step S34 to mount the chip component 20 on the printed substrate 3. Thereafter, the attracting nozzle 21 is raised at the step S35, and the head 23 is also raised at the step S36.

According to the method as shown in the flow chart of Fig.8, while the chip component 20 is attracted and mounted on the printed substrate 3, even if errors of direction and position of the chip component 20 are caused by scattering thereof, correction amounts corresponding to the errors are obtained in the processes at the steps S21 through S28 and the mounting position is corrected accordingly, and the chip component 20 is mounted accurately.

Since these operations are carried out while the chip component is being transferred to the mounting position after attraction, a series of operations from attraction to mounting are carried out efficiently.

Further, since the attracting nozzle 21 and the head 23 holding the nozzle 21 are both raised and lowered by respective servomotors 24 and 26, lowering (steps S14 and S15) and raising (steps S17 and S18) for attraction and lowering (steps S31 and S32) and raising (steps S34 and S35) for mounting are speeded up, which further improves the work efficiency.

At the step S26 of the flow chart of Fig.8, it is decided whether the component attraction is normal or not for a usual chip component 20 having its length of the shorter side different from its thickness, and the chip component attraction is decided to be normal if the minimum value of the projection width Wₘᵢₙ is nearly equal to the length of the shorter side.

However, among various chip components 20, there may be special shape chip components 20 having its length of the shorter side and its thickness nearly equal to each other. When such a component is used, even if the minimum value of the projection width is examined, it is impossible to distinguish the abnormal case where the component is erected making the thickness t be regarded as the minimum value Wₘᵢₙ of the projection width from the normal case where the shorter side length 1 becomes the minimum value Wₘᵢₙ of the projection width.

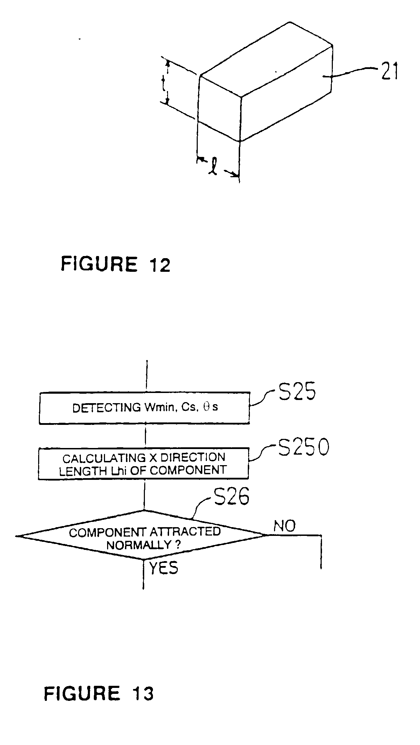

As a measure to such cases, it will do to modify part of the method shown in Fig.8 as shown in Fig.13. That is, a step S250 for calculating the X direction length Lₕᵢ of the component 20 is inserted between the steps S25 and S26, it is decided at the step S26 whether the component attraction is normal or not using the length Lₕᵢ, then the processes of the step S27 or the steps 528 and thereafter are carried out.

The X direction length Lₕᵢ of the component 20 is calculated at the step S250 as follows:

Taking, in Fig.11,
- Lₕᵢ (= L_{HI}):: X direction length of the component (length of the line segment hi equal to the length of the line segment HI), and
- Lij (= L_{IJ}):: length of the line segment ij (length of the line segment IJ),

W_{S} is given by:${\text{[eq. 7] W}}_{\text{S}} {\text{= L}}_{\text{hi}} {\text{·sin(θ}}_{\text{m}} {\text{+ θ}}_{\text{S}} {\text{) + L}}_{\text{ij}} {\text{·cos(θ}}_{\text{m}} {\text{+ θ}}_{\text{S}} \text{)}$ as shown in Fig.11. Since Lᵢⱼ = L_{IJ} = Wₘᵢₙ, the X direction length of the component Lₕᵢ is obtained by${\text{[eq. 8] L}}_{\text{hi}} {\text{= {(W}}_{\text{S}} {\text{- W}}_{\text{min}} {\text{·cos(θ}}_{\text{m}} {\text{+ θ}}_{\text{S}} {\text{)}/sin(θ}}_{\text{m}} {\text{+ θ}}_{\text{S}} \text{).}$

Since this X direction length Lₕᵢ of the component obtained above is to be the length of the longer side of the component if the component is attracted normally, in addition to the conditions in the decision at the step S26, if${\text{[eq. 9] L}}_{\text{hi}} \text{< (longer side length of the component) × (1 - β), or} {\text{L}}_{\text{hi}} \text{> (longer side length of the conponent) × (1 + β),}$ where β is a safety factor, the component attraction is decided abnormal.

The laser unit 31 installed on the lower end portion of the head unit 5 is utilized both for detecting the nozzle diameter and for detecting the chip component projection width for mounting position correction to simplify the structure.

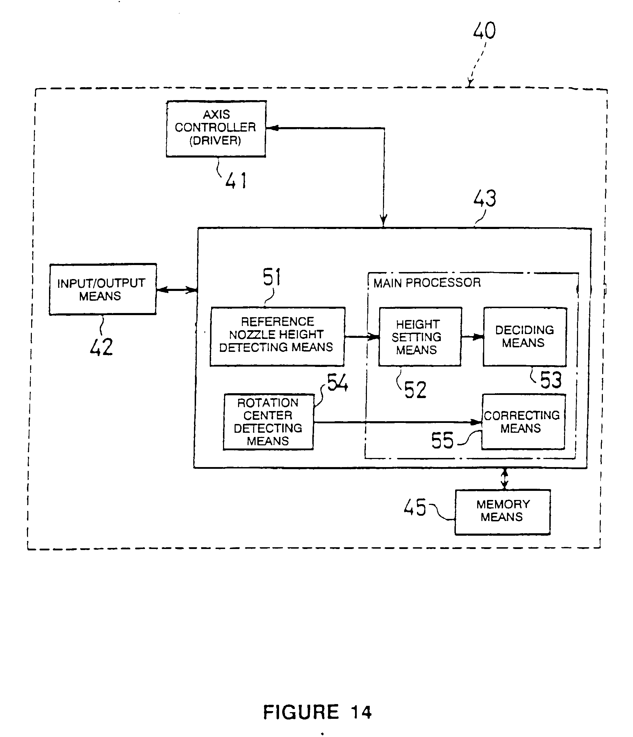

Fig. 14 shows another main controller 40 in the control system for a component mounting apparatus. Although omitted in Fig.14, various servomotors, position detecting means, laser unit processor, etc., to be connected to this main controller 40 are similar to those shown in Fig.5.

The main controller 40 above is provided, while being provided with an axis controller 41, input/output means 42 and main processor 43, with memory means 45.

The main processor 43 carries out various calculation processes required for the attracting and mounting operations for the chip components 20 as controls for the main operation of the component mounting apparatus. Further, the main processor 43 constitutes reference nozzle height detecting means 51 by, as nozzle element detecting process and the process based thereon in the preparatory operation stage, detecting the reference nozzle height which is the nozzle height obtained when the attracting nozzle tip end is brought to a position corresponding to the laser unit 31 by raising/lowering the attracting nozzle 21 and storing this height in the memory means 45. Further, it constitutes height setting means 52 by, when deciding the chip component attraction state by the deciding means 53 on the basis of the detection of the projection image of the chip component made by the laser unit after the chip component attraction during the main operation, setting the height position of the attracting nozzle on the basis of the reference nozzle height.

Further, the main processor 43 constitutes rotation center detecting means 54 by detecting, on the basis of the data obtained when detecting the projection image of the attracting nozzle by the laser unit 31 while rotating the attracting nozzle 21 on the preparatory operation stage, anc storing the rotation center of the attracting nozzle 21 in the memory means 45, while it constitutes correcting means by obtaining the discrepancies of the attracted position of the chip component on the basis of the data of the projection width of the chip component 20 obtained by the laser unit 31 while rotating the attracting nozzle 21 after chip component attraction in the main operation, and calculating the mounting position correction amounts coorresponding to the discrepancies above.

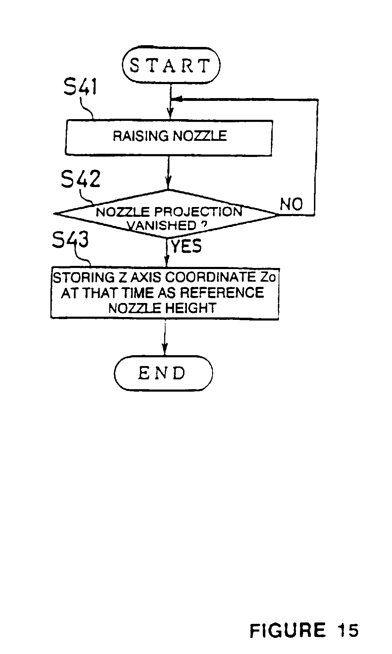

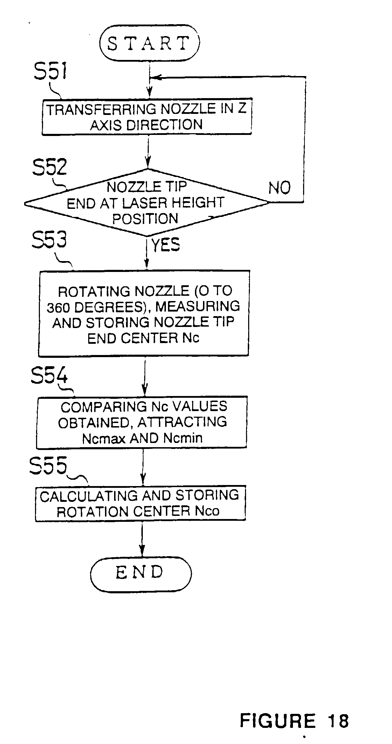

In this embodiment, after the attracting nozzle 21 is installed on the head unit 5, the function as the reference nozzle height detecting means 51 is carried out by the process shown in Fig.15, and the function as the rotation center detecting means 54 is carried out by the process shown in Fig.18. Althougn the control during the main operation is carried out as shown in the flow chart of Fig.8, the reference nozzle height detected by the reference nozzle height detecting means 51 and the rotation center detected by the rotation center detecting means 54 are used in the process of the steps S21 through S28 in this flow chart.

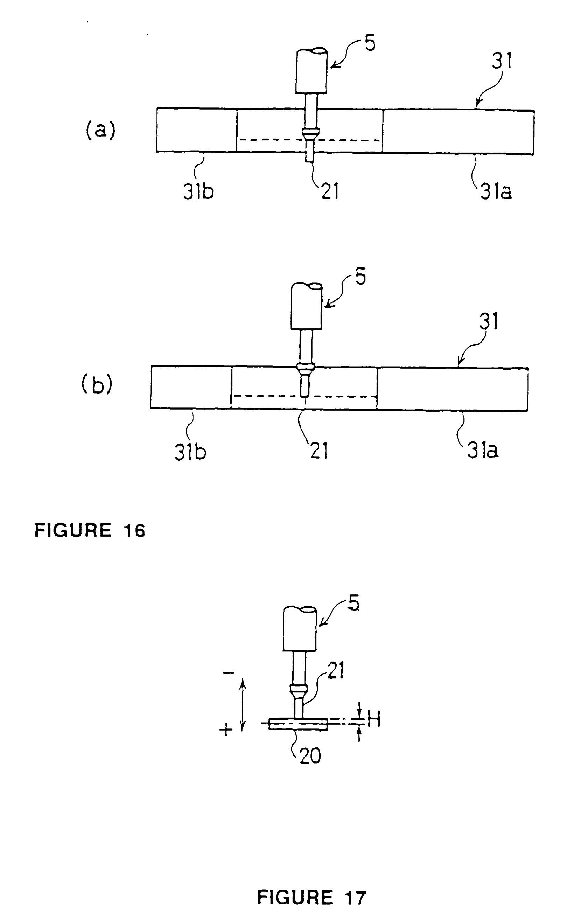

These processes are described hereafter referring to Figs.16, 17 and 19 through 21.

In the process of the reference nozzle height detecting means 51 shown in the flow chart of Fig.15, after installed on the head unit 5, the attracting nozzle 21 is raised at the step S41 from the state at the lowered position shown in Fig.16(a) by actuating the nozzle raising/lowering means such as the nozzle raising/lowering servomotor 26 or the like for raising/lowering the attracting nozzle 21 relative to the head unit 5 in the Z axis direction. At the next step S42, the projection of the attracting nozzle 21 is detected by the laser unit 31 and it is decided whether this projection of the attracting nozzle 21 has vanished or not. While the tip end of the attracting nozzle 21 is lower than the laser beam (shown in a broken line in Fig.16) emitting position, since the projection of the attracting nozzle 21 is detected and the decision at the step S42 is "NO", the program is returned to the step S41 to continue raising the attracting nozzle 21.

When the attracting nozzle 21 is raised to the position shown in Fig.16(b), namely to the position at which the tip end of the attracting nozzle 21 passes the laser emitting position of the laser unit 31, the laser beam begins not to be intercepted by the attracting nozzle 21 to make the decision at the step S42 "YES", and the procedure proceeds to the step S43 to store the Z axis coordinate Zₒ at that time in the memory means 45 as the reference nozzle height.

The reference nozzle height Zₒ is used for setting the recognizing height in the process (step S21) for raising the attracting nozzle 21 up to the recognizing height to decide the component attracting state, etc., on the basis of the detection of the projection of the chip component 20 in the process of the main operation shown in the flow chart of Fig.8. That is, taking the height from the upper end attracted surface of the chip component 20 to its region suitable for component recognition as H (See Fig.17), the recognizing height at the step S21 is determined as [Zₒ - H] from the height H and the reference nozzle height Zₒ above (provided that the downward direction is positive for the Z axis), and the attracting nozzle 21 is raised up to this height.

By such operations, the processes of the steps S22 through S28 are carried out correctly. That is, although a value preset according to the kind, etc., of the attracting nozzle can be used for setting the recognizing height, if only the preset value is used, the laser irradiating position of the chip component may be shifted from the proper position in the case where some scattering is caused in the nozzle height by an assembly error or the like. On the contrary, in this embodiment, the recognizing height is correctly adjusted by setting the recognizing height on the basis of the reference nozzle height Zₒ detected on the preparatory stage even if scattering of the reference nozzle height Zₒ is caused by assembly error, and processes of projection width detection and decision based thereon (step S26), correction (step S28), etc., will be carried out correctly.

Further, in the process of the rotation center detecting means 54 shown in the flow chart of Fig.18, the attracting nozzle 21 is raised/lowered in the Z axis direction (steps S51 and S52) by actuating the raising/lowering means until the tip end portion of the attracting nozzle 21 reaches the height position corresponding to the laser emitting position of the laser unit 31. Then, when the height position above is reached, while the attracting nozzle is rotated from 0 to 360 degrees by actuating the R axis servomotor 28 as rotation driving means, the center value of the attracting nozzle 21 is measured on the basis of the detection of the projection of the attracting nozzle 21 made by the laser unit 31, and is temporarily stored in the register (step S53).

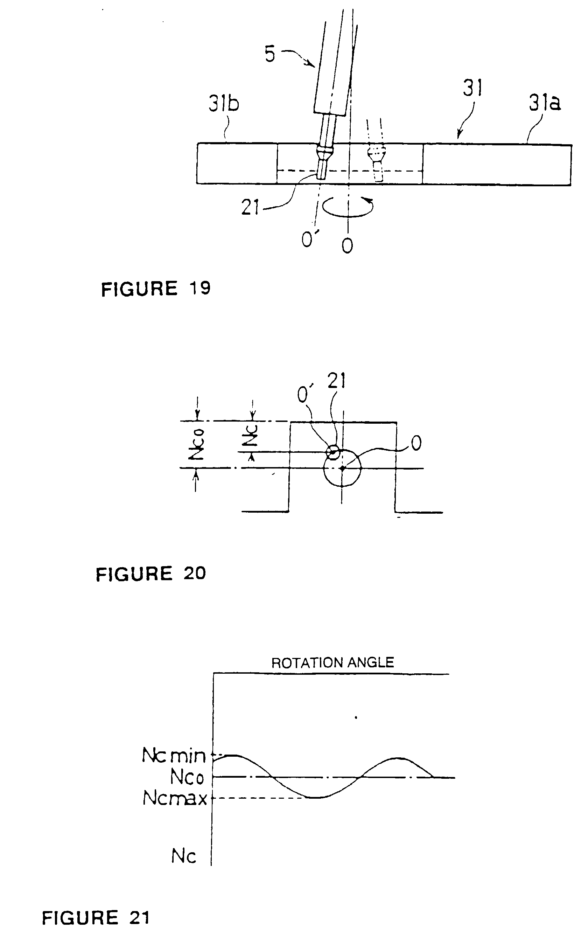

In this case, if the attracting nozzle 21 is installed obliquely relative to the R axis or if it is bent, the center 0' of the attracting nozzle does not coincide with the rotation center 0, and, if the attracting nozzle 21 is rotated in this state, the nozzle center 0' is moved circularly as shown in Fig.20, and the nozzle center 0' moves as shown in Fig.20 and the change of the nozzle center position in relation to the rotation angle becomes wavy as shown in Fig.21.

Therefore, at the step S54, the values of the nozzle center positions N_{c} detected while the attracting nozzle 21 is once rotated are compared with one another, their minumum and maximum values N_{cmin} and N_{cmax} are abstracted, then, at the step S55, the rotation center of the attracting nozzle N_{co} is calculated as follow:${\text{[eq.10] N}}_{\text{co}} {\text{= (N}}_{\text{cmin}} {\text{+ N}}_{\text{cmax}} \text{)/2.}$

This rotation center N_{co} is used in the process (step S28) as the correcting means for obtaining the component mounting position correction amounts X_{C}, Y_{C}and θ_{C} on the basis of the detection of the projection of the chip component 20 in the process of main operation shown in the flow chart of Fig.8. Practically, while the correction amounts X_{C}, Y_{C} and θ_{C} are obtained by the calculating equations [eq. 2] through [eq. 6] above, C_{N} included in the calculating equations is made the rotation center N_{co} above, that is, in this embodiment, the calculations of the correction amounts X_{C}, Y_{C} and θ_{C} are calculated by the calculating equations [eq. 2] through [eq. 6] after C_{N} included in the calculating equations is made N_{co}, that is, after C_{N} is substituted by N_{co} as C_{N} = N_{co}.

By such calculations, the accuracy of the component mounting position correction is improved. That is, even in the case where there is some discrepancy between the nozzle rotation center 0 and the nozzle center 0' because of the inclination of the attracting nozzle 21 caused by assembly error or because of the nozzle bend, the rotation center N_{co} of the attracting nozzle 21 is correctly obtained by the process as the rotation center detecting means 54 on the preparatory stage, and the discrepancy between the nozzle rotation center 0 and the chip component attracting position and the correction amount therefor will be detected correctly on the basis of this value N_{co} by the process as the correcting means at the step S28.

The example shown in Fig.14 is adapted for detecting the reference nozzle height and the nozzle rotation center by the reference nozzle height detecting means 51 and the rotation center detecting means 54, respectively, in the preparatory stage. Further, the decision whether the proper attracting nozzle 21 is installed or not on the basis of the nozzle diameter detection as shown above the detection of the reference nozzle height and the detection of the nozzle rotation center may be carried out collectively in the preparatory stage.

According to the component mounting method described above since the nozzle elements detecting process for detecting the elements representing the form or position of the attracting nozzle installed on the head unit is carried out after the attracting nozzle is installed on the head unit in the preparatory operation, and the deciding or setting process for the attracting nozzle is carried out on the basis of this nozzle elements detecting process, even in the case where there was miswork or assembly error when installing the attracting nozzle on the head unit, decision or adjustment for them can be made appropriately and various trouble caused by the miswork, etc., above can be prevented.

Moreover, according to the component mounting method described above and the apparatus for embodying this method, since the external form feature quantities of the attracting nozzle installed on the head unit are detected in the preparatory stage, and it is decided thereon whether the attracting nozzle installed is a proper one or not, even in the case where an improper attracting nozzle is installed on the head unit, it is possible to distinguish it from the proper one, and troubles such as defective attraction caused by using an improper attracting nozzle can be prevented.

Further, according to the component mounting method described above and the apparatus for embodying this method, since the reference nozzle height at which the tip end of the attracting nozzle is brought to the position corresponding to the optical detecting means is detected and stored after the attracting nozzle is installed, and the attracting nozzle is adjusted to the height obtained on the basis of the reference nozzle height above when detecting the projection of the chip component by the optical detecting means in the main operation, even if there is scattering in the attracting nozzle height positions because of assembly error, etc., the detection of the projection of the chip component made by the optical detecting means and the decision of the chip component attracted state based thereon can be carried out accurately.

In this method, if the projection width of the chip component is measured while rotating the nozzle attracting the chip component thereto within a definite rotational range to obtain the minimum projection width, maximum projection width and the rotation angle corresponding to the minimum projection width, and it is decided that the chip component attracted state is defective in any of the cases where the projection width minimum value is smaller than the lower limit side reference value, where the projection width maximum value is larger than the upper limit side reference value and where the rotation angle corresponding to the minimum projetion width does not exist within the definite rotation range above as the process for deciding the chip component attracted state, the chip component attracted state can be decided accurately.

Further, according to the component mounting method described above and the apparatus for embodying this method, since the rotation center of the attracting nozzle is detected and stored after the attracting nozzle is installed and, in the main operation thereafter, the discrepancy of the attracted position of the chip component is obtained on the basis of the projection of the chip component detected by the optical detecting means while rotating the attracting nozzle and the rotation center above, the component mounting position can be corrected accurately.

## Claims

1. Method for mounting chip components (20) at specific positions, preferably on a substrate such as a printed circuit board, comprising:
a main mounting operation, including the steps of attracting one of said components (20) by an attracting nozzle (21) associated with a moveable head unit (5) from a components supply unit (4), transferring the chip component (20), placing the same in a detection area of an optical detecting means (31), measuring the projection width (Wₛ) of the chip component (20) in the attracted state within the detection area (31) comprised of parallel light beams, and, subsequently, mounting the component at the desired position, and a preparatory nozzle detecting process preceding the main mounting operation for detecting whether or not the attracting nozzle (21) has a shape and/or position adapted to the chip component to be mounted **characterized in that** said optical detecting means (31) is also used for said preparatory nozzle detecting process and in that, during the main operation,
said chip component (20) is rotated and a projection width minimum value (Wₘᵢₙ) of the chip component (20) is detected.

2. Method as claimed in claim 1, **characterized in that,** in the projection width measurement of the main operation, the chip component (20) is rotated by a definite rotation angle range (θₑ), a rotation angle (θₘ) corresponding to the minimum value of the projection width (Wₘᵢₙ) is detected, and the attracted state of the chip component (20) is evaluated to be defective either when the projection width minimum value (Wₘᵢₙ) is smaller than a lower limit reference value which is set smaller by a predetermined amount than the shorter side of the chip component (20) and/or when the projection width minimum value (Wₘᵢₙ) is larger than a higher limit reference value which is set larger by a predetermined amount than the longer side of the chip component (20), and/or when the rotation angle (θₘ) corresponding to the projection width minimum value (Wₘᵢₙ) is outside the predetermined definite rotation angle range (θₑ).

3. Method as claimed in claim 1 or 2, **characterized by** calculating correction amounts (X_{c},Y_{c},θ_{c}) regarding the mounting position of the chip component (20) on the basis of the following data: a detected centre position (Cm) of the chip component (20) and the rotation angle (θₘ) at the minimum projection width (Wₘᵢₙ), and the centre position (C_{N}) of the attracting nozzle.

4. Method as claimed in at least one of the proceeding claims 1 to 3,
**characterized by** evaluating the attracted state of a special shaped chip component (20), having its length of the shorter side and its thickness nearly equal to each other, to be defective either when a calculated x-direction length (Lₕᵢ) of the component is smaller than the longer side length of the component multiplied by a predetermined lower safety value (1 - β), or when the calculated x-direction length (Lₕᵢ) of the chip component (20) is larger than the longer side length of the component (20) multiplied by a predetermined higher safety value (1 + β), wherein the x-direction is defined to be in line with the parallel light beams.

5. Method as claimed in at least one of the preceding claims 1 to 4,
**characterized in that,** in the preparatory nozzle detecting process, it is decided whether a certain attracting nozzle (21) installed is a proper one or not by comparing a detected external shape feature value with a set value indicative for the proper attracting nozzle (21), wherein the shape and/or position of the attracting nozzle (21) which is installed on the head unit (5) comprises said external shape feature value adjusted to the shape of the chip component (20) to be mounted.

6. Method as claimed in claim 5, **characterized in that,** in the preparatory nozzle detecting process, the nozzle diameter is detected as the external shape feature value.

7. Method according to at least one of the preceding claims 1 to 6, **characterized in that** the preparatory nozzle detecting process is performed each time ahead of the main operation for one of a plurality of attracting nozzles, detecting the correct place and/or orientation for said nozzle (21).

8. Apparatus for mounting chip components (20) at specific positions, preferably on a substrate such as a printed circuit board, comprising a moveable head unit (5) supporting an attracting nozzle (21) for attracting a chip component (20) by vacuum suction and transferring the same from a component supply side (4) to a component mounting side, means (26) for raising or lowering the attracting nozzle (21), optical detecting means (31) for detecting a shape and/or a position of the chip component including means for detecting the projection width of the chip component (20) by parallel light beams emitted from a beam emitting portion (31a) and received by a light beam receiving portion (31b) provided on the head unit (5), and a main control unit (43) for controlling the mounting operation, **characterized in that** the apparatus is arranged to use the same optical detecting means (31) for detecting whether or not the attracting nozzle has a shape and/or a position adapted to the chip component to be mounted, and in that the apparatus further comprises servo motors (9,15) for moving the head unit (5) and, hence, the nozzle (21) and the chip component (20) attracted thereto in a direction (X) in line with the parallel light beams and in a direction (Y) perpendicular thereto, respectively, means (28) for rotating the nozzle (21) and thereby the chip component (20) attracted thereto, and calculating means for calculating chip component mounting correction amounts (X_{c}, Y_{c}, θ_{c}) on basis of the data detected by said optical detection means (31) when detecting the rotational position of the chip component which is varied in order to measure the projection width minimum value (Wₘᵢₙ) of the chip component.

9. Apparatus as claimed in claim 8, **characterized in that** said optical detecting means (31) detects the diameter of the attracting nozzle (21), in that a nozzle feature quantity memory means (44) is provided and in that said main control unit (43) compares the detected diameter value with the nozzle diameter of the proper attracting nozzle (21) adapted to the chip component (20) to be mounted.

## Patentansprüche

1. Verfahren zum Montieren von Chip-Bauteilen (20) an bestimmten Positionen, vorzugsweise auf einem Substrat wie einer gedruckten Leiterplatte, mit: einem Hauptmontage-Arbeitsablauf mit den Schritten des Anziehens eines der Bauteile (20) durch eine einer bewegbaren Kopfeinheit (5) zugeordneten Anziehungsdüse (21) von einer Bauteil-Zuführeinheit (4), Überführen des Chip-Bauteils (20), Einsetzen desselben in einen Erfassungsbereich eines optischen Erfassungsmittels (31), Messen der Projektionsbreite (Wₛ) des Chip-Bauteils (20) im angezogenen Zustand in dem aus parallelen Lichtstrahlen gebildeten Erfassungsbereich, und darauffolgendes Montieren des Bauteils an der gewünschten Position, und mit einem vorbereitenden Düsen-Erfassungsvorgang, der dem Hauptmontage-Arbeitsablauf vorangeht, um zu erfassen, ob die Anziehungsdüse (21) eine für das zu montierende Chip-Bauteil ausgelegte Form und/oder Position besitzt, **dadurch gekennzeichnet, dass** das optische Erfassungsmittel (31) auch für den vorbereitenden Düsenerfassungsvorgang benutzt wird, und dass während des Haupt-Arbeitsablaufs das Chip-Bauteil (20) gedreht und ein Projektionsbreiten-Minimalwert (Wₘᵢₙ) des Chip-Bauteils (20) erfasst wird.

2. Verfahren nach Anspruch 1, **dadurch gekennzeichnet, dass** bei der Projektionsbreiten-Messung des Haupt-Arbeitsablaufs das Chip-Bauteil (20) um einen bestimmten Drehwinkelbereich (θₑ) gedreht wird, dass ein dem Minimalwert der Projektionsbreite (Wₘᵢₙ) entsprechender Drehwinkel (θₘ) erfasst wird, und der Anziehungszustand des Chip-Bauteils (20) als fehlerhaft bewertet wird, wenn entweder der Projektionsbreiten-Minimalwert (Wₘᵢₙ) kleiner als ein unterer Grenzreferenzwert ist, der um eine vorgegebene Größe kleiner als die kürzere Seite des Chip-Bauteils (20) festgesetzt ist, und/oder wenn der Projektionsbreiten-Minimalwert (Wₘᵢₙ) größer als ein höherer Grenzreferenzwert ist, der um eine vorgegebene Größe größer als die längere Seite des Chip-Bauteils (20) festgesetzt ist, und/oder wenn der dem Projektionsbreiten-Minimalwert (Wₘᵢₙ) entsprechende Drehwinkel (θₘ) außerhalb des vorgegebenen bestimmten Drehwinkelbereichs (θₑ) liegt.

3. Verfahren nach Anspruch 1 oder 2, **gekennzeichnet durch** Berechnen von Korrekturgrößen (X_{c}, Y_{c}, θ_{c}) betreffend die Montageposition des Chip-Bauteils (20) aufgrund der folgenden Daten: eine erfasste Mittelposition (Cm) des Chip-Bauteils (20) und dem Drehwinkel (θₘ) bei der minimalen Projektionsbreite (Wₘᵢₙ) und der Mittelposition (C_{N}) der Anziehungsdüse.

4. Verfahren nach mindestens einem der vorangehenden Ansprüche 1 bis 3, **gekennzeichnet durch** Bewerten des angezogenen Zustands eines speziell geformten Chip-Bauteils (20), bei dem die Länge der kürzeren Seite und die Dicke einander nahezu gleich sind, als fehlerhaft, wenn entweder eine berechnete Länge in X-Richtung (Lₕᵢ) des Bauteils kleiner als die mit einem vorgegebenen kleineren Sicherheitswert (1-β) multiplizierte längere Seitenlänge des Bauteils ist, oder wenn die berechnete Länge in X-Richtung (Lₕᵢ) des Chip-Bauteils (20) größer als die mit einem vorgegebenen höheren Sicherheitswert (1+β) multiplizierte längere Seitenlänge des Bauteils (20) ist, wobei die X-Richtung als mit den parallelen Lichtstrahlen ausgerichtet definiert ist.

5. Verfahren nach mindestens einem der vorangehenden Ansprüche 1 bis 4, dadurch **gekennzeichnet, dass** in dem vorbereitenden Düsenerfassungsvorgang entschieden wird, ob eine bestimmte installierte Anziehungsdüse (21) eine geeignete Düse ist oder nicht durch Vergleichen eines erfassten externen Formmerkmalwertes mit einem als für die geeignete Anziehungsdüse (21) bezeichnend festgesetzten Wert, wobei die Form und/ oder Position der an der Kopfeinheit (5) installierten Anziehungsdüse (1) den an die Form des zu montierenden Chip-Bauteils (20) angepassten externen Formmerkmalwert umfasst.

6. Verfahren nach Anspruch 5, **dadurch gekennzeichnet, dass** in dem vorbereitenden Düsenerfassungsvorgang der Düsendurchmesser als der externe Formmerkmalwert erfasst wird.

7. Verfahren nach mindestens einem der vorangehenden Ansprüche 1 bis 6, dadurch **gekennzeichnet, dass** der vorbereitende Düsenerfassungsvorgang jedesmal vor dem Hauptablauf für eine aus einer Vielzahl von Anziehungsdüsen ausgeführt wird, mit Erfassen der korrekten Stelle und/oder Ausrichtung für die Düse (21).

8. Vorrichtung zum Montieren von Chip-Bauteilen (20) an bestimmten Positionen, vorzugsweise an einem Substrat wie einer gedruckten Leiterplatte mit einer bewegbaren Kopfeinheit (5), die eine Anziehungsdüse (21) zum Anziehen eines Chip-Bauteils (20) durch Unterdruck-Ansaugen und Übertragen derselben von einer Komponentenzuführseite (4) zu einer Komponentenmontageseite trägt, mit Mitteln (26) zum Anheben oder Absenken der Ansaugungsdüse (21), optischem Erfassungsmittel (31) zum Erfassen einer Form und/oder einer Position des Chip-Bauteils, einschließlich Mitteln zum Erfassen der Projektionsbreite des Chip-Bauteils (20) durch von einem Strahlemittierungsabschnitt (31a) emittierten parallelen Lichtstrahlen, die durch einen an der Kopfeinheit (5) vorgesehenen Lichtstrahl-Aufnahmeabschnitt (31b) aufgenommen werden, und einer Hauptsteuereinheit (43) zum Steuern des Montageablaufes, **dadurch gekennzeichnet, dass** die Vorrichtung ausgelegt ist, das gleiche optische Erfassungsmittel (31) zu verwenden, um zu erfassen, ob die Anziehungsdüse eine an das zu montierende Bauteil angepaßte Form und/oder eine solche Position besitzt oder nicht, und dass die Vorrichtung weiter Servomotore (9, 15) zum Bewegen der Kopfeinheit (5) und damit der Düse (21) und dem dadurch angezogenen Chip-Bauteil (20) in einer mit den parallelen Lichtstrahlen ausgerichteten Richtung (X) bzw. in einer dazu senkrechten Richtung (Y), sowie Mittel zum Drehen der Düse (21) und dadurch des daran angezogenen Chip-Bauteils (20) und Berechnungsmittel zum Berechnen von Chip-Bauteil-Montagekorrekturgrößen (X_{c}, Y_{c}, θ_{c}) aufgrund der durch das optische Erfassungsmittel (31) beim Erfassen der Drehposition des Chip-Bauteils erfassten Daten umfasst, wobei die Drehposition variiert wird, um den Projektionsbreiten-Minimalwert (Wₘᵢₙ) des Chip-Bauteils zu messen.

9. Vorrichtung nach Anspruch 8, **dadurch gekennzeichnet, dass** das optische Erfassungsmittel (31) den Durchmesser der Anziehungsdüse (21) erfasst, dass ein Düsenmerkmalgrößen-Speichermittel (44) vorgesehen ist, und dass die Hauptsteuereinheit (33) den erfassten Durchmesserwert mit dem Düsendurchmesser der geeigneten auf den zu montierenden Chip-Bauteil (20) ausgelegten Anziehungsdüse (21) vergleicht.

## Revendications

1. Procédé de montage de composants en forme de pastille (20) en des positions spécifiques, de préférence sur un substrat comme une carte à circuits imprimés, comprenant :
une opération principale de montage, incluant les étapes d'attraction de l'un des composants (20) au moyen d'une buse d'attraction (21) associée à une unité de tête mobile (5) à partir d'une unité d'alimentation des composants (4), de transfert du composant en forme de pastille (20), de placement de ce composant dans une zone de détection d'un moyen de détection optique (31), de mesure de la largeur de projection (Wₛ) du composant en forme de pastille (20) en état attiré dans la zone de détection (31) constituée de rayons lumineux parallèles, puis de montage du composant à l'endroit désiré et un processus préparatoire de détection de buse avant l'opération principale de montage afin de détecter si la buse d'attraction (21) a ou non une forme et/ou une position adaptées au composant en forme de pastille à monter, caractérisé en ce que ledit moyen de détection optique (31) est également utilisé pendant ledit processus préparatoire de détection de buse et en ce que, pendant l'opération principale, ledit composant en forme de pastille (20) subit une rotation et qu'une valeur minimum de largeur de projection (Wₘᵢₙ) du composant en forme de pastille (20) est détectée.

2. Procédé selon la revendication 1, caractérisé en ce que, lors de la mesure de la largeur de projection de l'opération principale, le composant en forme de pastille (20) subit une rotation dans une plage d'angles de rotation définie (θₑ), un angle de rotation (θₘ) correspondant à la valeur minimum de la largeur de projection (Wₘᵢₙ) est détecté et l'état attiré du composant en forme de pastille (20) est évalué comme étant défectueux lorsque la valeur minimum de la largeur de projection (Wₘᵢₙ) est inférieure à une valeur de référence de limite inférieure, qui est réglée pour être inférieure d'une valeur prédéterminée au côté le plus petit du composant en forme de pastille (20) et/ou lorsque la valeur minimum de la largeur de projection (Wₘᵢₙ) est supérieure à une valeur de référence de limite supérieure, qui est réglée pour être supérieure d'une valeur prédéterminée au côté le plus long du composant en forme de pastille (20) et/ou lorsque l'angle de rotation (θₘ) correspondant à la valeur minimum de la largeur de projection (Wₘᵢₙ) est en dehors de la plage d'angles de rotation définie prédéterminée (θₑ).

3. Procédé selon la revendication 1 ou 2, caractérisé par un calcul des valeurs de correction (X_{c}, Y_{c}, θₑ) concernant la position de montage du composant en forme de pastille (20) sur la base des données suivantes : une position centrale détectée (Cm) du composant en forme de pastille (20) et l'angle de rotation (θₘ) à la largeur de projection minimum (Wₘᵢₙ) et la position centrale (Cn) de la buse d'attraction.

4. Procédé selon l'une au moins des revendications 1 ou 3 précédentes, caractérisé par une évaluation de l'état attiré d'un composant en forme de pastille de forme spéciale (20), dont la longueur du petit côté et l'épaisseur sont pratiquement égales, comme étant défectueux lorsqu'une longueur calculée dans la direction x (Lₕᵢ) du composant est inférieure à la longueur du côté le plus long du composant multipliée par une valeur de sécurité inférieure prédéterminée (1 - β) ou lorsque la longueur calculée dans la direction x (Lₕᵢ) du composant (20) est supérieure à la longueur du côté le plus long du composant (20) multipliée par une valeur de sécurité supérieure prédéterminée (1 + β), où la direction x est définie pour être alignée avec les faisceaux lumineux parallèles.

5. Procédé selon l'une au moins des revendications 1 ou 4 précédentes, caractérisé en ce que, lors du processus préparatoire de détection de buse, il est décidé si une certaine buse d'attraction (21) installée est adéquate ou non en comparant une valeur caractéristique de forme extérieure détectée avec une valeur de consigne représentant une buse d'attraction (21) adéquate, où la forme et/ou la position de la buse d'attraction (21), qui est installée sur l'unité de tête (5), comprend ladite valeur caractéristique de forme extérieure ajustée à la forme du composant en forme de pastille (20) à monter.

6. Procédé selon la revendication 5, caractérisé en ce que, lors du processus préparatoire de détection de buse, le diamètre de la buse est détecté comme la valeur caractéristique de forme extérieure.

7. Procédé selon l'une au moins des revendications 1 ou 6 précédentes, caractérisé en ce que le processus préparatoire de détection de buse est exécuté avant chaque opération principale pour une buse d'une pluralité de buses d'attraction afin de détecter la place et/ou l'orientation correctes de ladite buse (21).

8. Appareil pour monter des composants en forme de pastille (20) en des positions spécifiques, de préférence sur un substrat comme une carte à circuits imprimés, comprenant une unité de tête mobile (5) supportant une buse d'attraction (21) afin d'attirer un composant en forme de pastille (20) par aspiration par le vide et de transférer ce composant d'un côté alimentation des composants (4) vers un côté montage des composants, un moyen (26) destiné à lever et abaisser la buse d'attraction (21), un moyen de détection optique (31) destiné à détecter une forme et/ou une position du composant en forme de pastille incluant un moyen pour détecter la largeur de projection du composant en forme de pastille (20) à l'aide de faisceaux lumineux parallèles émis par une partie émettrice de faisceaux (31a) et reçus par une partie réceptrice de faisceaux lumineux (31b) placées sur l'unité de tête (5) et une unité de commande principale (43) destinée à commander l'opération de montage, caractérisé en ce que l'appareil est conçu pour utiliser le même moyen de détection optique (31) pour détecter si la buse d'attraction a ou non une forme et/ou une position adaptées au composant en forme de pastille à monter, et en ce que l'appareil comprend, en outre, des servomoteurs (9, 15) destinés à déplacer l'unité de tête (5) et donc la buse (21) et le composant en forme de pastille (20) attiré sur cette buse, respectivement, dans une direction (X) alignée avec les faisceaux lumineux parallèles et dans une direction (Y) perpendiculaire à ces faisceaux, un moyen (28) destiné à faire tourner la buse (21) et donc le composant en forme de pastille (20) attiré sur celle-ci et un moyen de calcul destiné à calculer des valeurs de correction de montage du composant en forme de pastille (X_{c}, Y_{c}, θₑ) sur la base des données détectées par ledit moyen de détection optique (31) lors de la détection de la position de rotation du composant en forme de pastille qui est changée afin de pouvoir mesurer la valeur minimum de la largeur de projection (Wₘᵢₙ) du composant en forme de pastille.

9. Appareil selon la revendication 8, caractérisé en ce que le moyen de détection optique (31) détecte le diamètre de la buse d'attraction (21), en ce qu'un moyen de mémoire de valeurs caractéristiques de buse (44) est fourni et en ce que ladite unité de commande principale (43) compare la valeur de diamètre détectée avec le diamètre de la buse d'attraction (21) adéquate, adaptée au composant en forme de pastille (20) à monter.
